# EUROPÄISCHE PATENTSCHRIFT

(11) **EP 2 010 878 B1**
(45) Veröffentlichungstag und Bekanntmachung des Hinweises auf die Patenterteilung: **08.05.2013**
(21) Anmeldenummer: 07726703.7
(22) Anmeldetag: 07.03.2007
(51) Int. Cl.: G01J 5/00, C30B 13/24, H01L 21/00

(54) **VERFAHREN ZUR PYROMETRISCHEN MESSUNG DER TEMPERATUR DES SCHMELZGUTES IN EINKRISTALLZÜCHTUNGSANLAGEN**
METHOD FOR PYROMETRICALLY MEASURING THE TEMPERATURE OF THE MELT MATERIAL IN MONOCRYSTAL CULTIVATION SYSTEMS
PROCÉDÉ DE MESURE PYROMÉTRIQUE DE LA TEMPÉRATURE DE LA MATIÈRE FONDUE DANS DES ÉQUIPEMENTS DE CROISSANCE DE MONOCRISTAL

(30) Priorität: 21.04.2006 DE 102006019807
(43) Veröffentlichungstag der Anmeldung: 07.01.2009
(73) Patentinhaber: Leibniz-Institut für Festkörper- und Werkstoffforschung E.V., 01069 Dresden (DE)
(72) Erfinder: BEHR, Günter, 01705 Freital (DE); VOIGTLÄNDER, Ralf, 01309 Dresden (DE); HORST, Alexander, 01129 Dresden (DE); MORGNER, Rolf, 01279 Dresden (DE); FISCHER, Friedrich, 01189 Dresden (DE)
(74) Vertreter: Rauschenbach, Marion
(86) Internationale Anmeldenummer: PCT/EP2007/052157
(87) Internationale Veröffentlichungsnummer: WO 2007/122038

(56) Entgegenhaltungen:
- WO-A-91/02833
- US-A1- 2003 183 612
- US-A1- 2004 060 917
- US-A1- 2005 025 691
- US-B1- 6 200 634

## Beschreibung

Die Erfindung bezieht sich auf das Gebiet der Messtechnik und betrifft ein Verfahren zur pyrometrischen Messung der Temperatur des Schmelzgutes in Einkristallzüchtungsanlagen.

Eine in Wissenschaft und Industrie verbreitete Methode zur Erwärmung von Materialien, z.B. zum Zwecke der Umwandlung, Umformung oder des Schmelzens ist die Anwendung von Strahlung, welche die jeweils benötigte Wellenlänge, z.B. im Infrarotbereich oder im Bereich des sichtbaren Lichtes beinhaltet. Dabei sind auch genaue Bestimmungen der Temperatur, auf die das Material erwärmt wird, technologisch wichtig.

Eine kontaktbehaftete Temperaturmessung mit Temperaturfühlern, z.B. Thermoelementen kann in der Regel aus technologischen Gründen nicht angewandt werden.

Daher wird standardmäßig eine kontaktlose Temperaturmessung mittels eines Pyrometers eingesetzt, die aus anderen Erwärmungsverfahren, beispielsweise induktiv, bekannt ist.

Das grundsätzliche Messproblem im Falle der Erwärmung eines Materials mittels Strahlung ist, dass prinzipbedingt die Temperatur des Strahlers höher ist als die Temperatur des bestrahlten Materials. Damit wird bei der Pyrometermessung nach dem Stand der Technik die Temperatur des Strahlers ermittelt, da vor dessen Hintergrund die Messung der niedrigeren Materialtemperatur nicht möglich ist.

Um dafür eine Lösung zu finden, wurde ein blitzunterstütztes Multi-Wellenlängen-Pyrometer entwickelt (Rev. Sci. Instr. 70 (1999) 6, S. 2719-2727). Mit diesem Verfahren ist die In-situ-Ermittlung der Emissions- und Reflexionsfaktoren der Materialprobe in Abhängigkeit von der Wellenlänge mittels einer zusätzlichen BlitzLichtquelle möglich. Zusätzlich wird eine gekühlte kalibrierte Probe des gleichen Materials als Reflexionsstandard benötigt. Ein Spektrometer erfasst über zwei Kanäle die Strahlungen von Probe und Standard, jeweils mit und ohne Präsenz der Blitzlichtquelle. Aus den Werten wird, basierend auf Modellannahmen, in einem umfangreichen numerischen Verfahren eine Probentemperatur errechnet.

Die Nachteile dieses Messverfahrens sind sein komplizierter und nicht praxistauglicher Messaufbau, die Schwierigkeit der Anordnung der Standardprobe in der Nähe der Messprobe, was oft nur schwer realisierbar ist, die Schwierigkeit der sicheren Ermittlung der Temperatur auf der Basis der Emissions- und Reflexionsfaktoren des Materials. Der letzte Punkt gilt insbesondere für Schmelzen, da bei diesen der Emissionsfaktor a priori unbekannt ist.

Bei einem weiteren bekannten Verfahren wird zwischen Strahlungsquelle und dem zu erwärmenden Material ein Filter aus einem speziellen Quarzglas angeordnet (Gaus, R, u.a., Tagungsband DVM Werkstoffprüfung, Bad Nauheim 1993). Der Filter weist ein ausgeprägtes Absorbtionsband im Wellenlängenbereich um 2,74 µm auf.

Das verwendete Pyrometer ist exakt auf diesen Wellenlängenbereich abgestimmt. Die resultierende Strahlung von der Oberfläche des Messobjektes wird gemessen und über einen Algorithmus auf die Oberflächentemperatur umgerechnet. Voraussetzung hierfür ist, dass der Emissionskoeffizient der Probe bekannt ist, was in der Praxis selten der Fall ist.

Aus diesem Grunde werden meist Quotientenpyrometer verwendet, bei denen sich der Temperatur-Messwert aus dem Verhältnis der gemessenen Amplituden bei zwei unterschiedlichen Wellenlängen ergibt, wodurch der Einfluss des Emissionskoeffizienten auf das Messergebnis weitgehend eliminiert wird.

Das Filterverfahren ist jedoch wegen seiner nur einen freien Messwellenlänge prinzipbedingt nicht für Quotientenpyrometer anwendbar und deshalb für die meisten Temperaturmessungen unter Präsenz von Wärme- oder Lichtstrahlung nicht anwendbar.

Ähnliche Verfahren sind aus US 5,154,512 und US 5,318,362 bekannt, wobei hier die Funktion des Ausfilterns der Messwellenlänge aus der Erwärmungsstrahlung durch einen speziellen Spiegel realisiert wird. Auch diese Verfahren sind für Quotientenpyrometer nicht anwendbar.

Ein weiteres Verfahren zur Temperaturmessung (US 5,154,512; US 5,318,362) geht von einer AC-Versorgungsspannung der Strahlungsquelle aus und wertet den Zeitverlauf der Strahlung aus. So beträgt bei einer mit einer 50-Hz-Spannung gespeiste Lampe die Ripplefrequenz der Lichtintensität 100 Hz. Dieses Prinzip sieht vor, die vom Messobjekt kommende Gesamtstrahlung in zeitlicher Auflösung zu erfassen und von diesem Zeitverlauf den 100-Hz-Anteil zu subtrahieren. Aber auch dieses Verfahren ist nicht sehr praktikabel, da der Messbereich des Pyrometers den Temperaturbereich des Strahlers selbst mit einschließen muss. In der Regel ist aber die Temperaturdifferenz zwischen der erwärmenden Strahlung und dem erwärmten Messobjekt so hoch, dass der Sensor des Pyrometers übersteuert wird. Weiterhin ist nachteilig, dass die Größe des AC-Anteiles im Zeitverlauf der Lichtintensität von der Art des Strahlers abhängt. Je größer die beteiligte Masse im strahlungserzeugenden Teil ist, umso stärker wird dieser Ripple der Leistungsschwankung geglättet. Auch nachteilig ist, dass das Verfahren generell nicht anwendbar ist, wenn der Strahler mit einer DC-Speisung versehen ist.

Aufgabe der Erfindung ist es, ein Verfahren zur pyrometrischen Messung der Temperatur des Schmelzgutes in Einkristallzüchtungsanlagen anzugeben, mit dem unbeeinflusst von anderen Wärmestrahlern die Temperatur des Schmelzgutes ermittelt werden kann.

Die Aufgabe wird durch die in den Ansprüchen angegebene Erfindung gelöst. Vorteilhafte Ausgestaltungen sind Gegenstand der Unteransprüche.

Bei dem erfindungsgemäßen Verfahren zur pyrometrischen Messung der Temperatur oder der Temperaturverteilung mindestens der Schmelze in Einkristallzüchtungsanlagen wird der Schmelzbereich mittels einer oder mehreren Strahlungsquellen, die mindestens einen IR-Strahlungsanteil enthalten, erwärmt, und für eine oder mehrere Temperaturmessungen die Einwirkung der Strahlungsquellen auf den Schmelzbereich unterbrochen und wobei die eine oder mehrere Temperaturmessungen ausschließlich während des Unterbrechungszeitraumes durchgeführt werden, wobei die Unterbrechung mindestens bis zur t₉₀-Zeit des Pyrometers durchgeführt wird.

Vorteilhafterweise wird die Unterbrechung der Einwirkung der Strahlungsquellen auf den Schmelzbereich mittels einer oder mehrerer Einrichtungen vorgenommen, die in den Strahlengang zwischen Strahlungsquelle und Schmelzbereich eingebracht werden.

Ebenfalls vorteilhafterweise werden für die Temperaturmessung ein oder mehrere Quotienten-Pyrometer mit einer Einschwingzeit t₉₀ von < 10 ms eingesetzt.

Weiterhin vorteilhafterweise wird die Einwirkung der Strahlungsquellen auf den Schmelzbereich für eine Zeitdauer im Bereich von 2 ms bis 10 s unterbrochen.

Vorteilhaft ist es auch, wenn der pyrometrische Messvorgang im mittleren Bereich des Unterbrechungszeitraumes durchgeführt wird.

Und auch vorteilhaft ist es, wenn der pyrometrische Messvorgang während einer Zeitdauer im Bereich von 10 ms bis 80 ms durchgeführt wird.

Von Vorteil ist es auch, wenn die Synchronisation des pyrometrischen Messvorganges mit der Unterbrechung der Einwirkung der Wärmestrahlungsquellen und die Auswertung der Messung elektronisch durchgeführt werden.

Ebenfalls von Vorteil ist es, wenn die Unterbrechung bis zu dem 10 bis 50fachen der t₉₀-Zeit des Pyrometers durchgeführt wird, wobei die t₉₀-Zeit die Zeit bis zur Anzeige von 90 % des Messwertes ist.

Die erfindungsgemäße Vorrichtung zur pyrometrischen Messung der Temperatur oder der Temperaturverteilung mindestens der Schmelze in Einkristallzüchtungsanlagen besteht aus mindestens einer Strahlungsquelle mit mindestens einem IR-Strahlungsanteil, mindestens einem Pyrometer und mindestens einer Einrichtung zur Unterbrechung der Einwirkungen der Strahlungsquelle auf den Strahlungsbereich.

Vorteilhafterweise ist die Strahlungsquelle eine IR-Lampe oder eine Halogenlampe oder eine Lichtbogenlampe.

Ebenfalls vorteilhafterweise sind als Pyrometer ein oder mehrere Quotientenpyrometer vorhanden.

Von Vorteil ist es, wenn die Einrichtungen zur Unterbrechung der Einwirkung der Strahlungsquelle auf den Strahlungsbereich eine oder mehrere strahlungsdichte Blenden, ein oder mehrere Flüssigkristalle oder eine Vorrichtung zur Veränderung der Strahlungsrichtung der Strahlungsquelle sind.

Dabei sind vorteilhafterweise eine oder mehrere strahlungsdichte Blenden innerhalb eines Ringes angeordnet und der Ring ist einer kreisförmigen Bewegung unterworfen, und/oder die Flüssigkristalle sind periodisch mit einer Spannung beauflagt, die sie zeitweise für den Durchgang von mindestens IR-Strahlung undurchlässig machen und/oder als Vorrichtung zur Veränderung der Strahlungsrichtung der Strahlungsquelle sind ein Schwenkmechanismus für die Strahlungsquelle oder ein Schwenkmechanismus für Fokussierungseinrichtungen vorhanden.

Mit dem erfindungsgemäßen Verfahren wird es möglich, auch bei Einsatz von Strahlungsquellen mit mindestens einem IR-Strahlungsanteil die Temperatur oder die Temperaturverteilung mindestens des Schmelzbereiches von Einkristallzüchtungsanlagen zu ermitteln. Nach dem Stand der Technik war keine Temperatur oder Temperaturverteilung des Schmelzbereiches von Einkristallzüchtungsanlagen mit einer Strahlungsquelle mit mindestens einem IR-Strahlungsanteil messbar, da der IR-Strahlungsanteil der Strahlungsquelle die Temperaturmessung des Schmelzbereiches verfälschte. Durch die Unterbrechung der Einwirkung der Strahlungsquelle auf den Schmelzbereich kann während der Unterbrechung die tatsächliche Temperatur oder Temperaturverteilung des Schmelzbereiches und auch der daran angrenzenden Materialbereiche gemessen werden. Dabei muss die vollständige Unterbrechung mindestens der t₉₀-Zeit des jeweils verwendeten Pyrometers entsprechen. Diese t₉₀-Zeit ist die Zeit, in der die Anzeige des Pyrometers 90 % des Messwertes erreicht hat. Diese t₉₀-Zeiten sind für Pyrometer aus ihren Datenblättern bekannt und ermittelbar. Die Länge des Unterbrechungszeitraumes wird andererseits begrenzt durch den Einkristallzüchtungsvorgang selbst. Der Einkristallzüchtungsvorgang darf möglichst nicht oder nur unwesentlich beeinflusst werden.

Bei den erfindungsgemäßen Vorrichtungen zur Unterbrechung der Einwirkungen der Strahlungsquelle auf den Strahlungsbereich kann es sich beispielsweise um strahlungsdichte Blenden handeln, die vorteilhafterweise innerhalb eines Ringes angeordnet sind und sich durch die kreisförmige Bewegung des Ringes periodisch in den Strahlengang zwischen Strahlungsquelle und Schmelzbereich ein- und wieder ausblenden. Dabei wird als Unterbrechungszeitraum nur der Zeitraum des Kernschattens der Blende berücksichtigt. Eine weitere vorteilhafte Möglichkeit besteht in dem Hineinschieben einer Blende in den Strahlengang zwischen Strahlungsquelle und Schmelzbereich.

Im Falle des Einsatzes von umschaltbaren Flüssigkristallen ist es vorteilhaft, ebenfalls eine vollständige Unterbrechung des Strahlenganges zwischen Strahlungsquelle und Schmelzbereich zu erreichen. Mindestens muss aber die Unterbrechung des Durchganges von IR-Strahlung realisiert sein.

Eine weitere Möglichkeit zur Unterbrechung der Einwirkung der Strahlungsquelle auf den Schmelzbereich besteht in der Änderung der Strahlungsrichtung der Strahlungsquelle. Dazu kann beispielsweise die Strahlungsquelle für den Unterbrechungszeitraum aus der ursprünglichen Strahlungsrichtung geschwenkt und dann wieder zurückgeführt werden.

Nachfolgend wird die Erfindung an einem Ausführungsbeispiel näher erläutert.

### Beispiel 1

Der Schmelzbereich einer Einkristallzüchtungsanlage zur Züchtung von Er₂PdSi₃ Einkristallen wird mittels einer Xenon-Hochdruck-Lichtbogenlampe, die eine Strahlung im Wellenlängenbereich von 240 bis über 2000 nm mit einer Leistung von 5kW abgibt, erwärmt. Die Blende hat die Form eines Kreissegmentes mit einem Winkel von 150° und besteht aus geschwärztem Aluminiumblech. Die Blende unterbricht den Lichtstrahlkegel bei einem Durchmesser von 100mm, normal zur Achse des Lichtstrahlkegels. Diese Blende wird durch den Antrieb mit einer Winkelgeschwindigkeit zum Zeitpunkt des Kernschattens von 0.9*10⁶°/min durch den Strahlengang zwischen der Xenon-Hochdruck-Lichtbogenlampe und dem Schmelzbereich hindurchgedreht. Während dieses gesamten Vorganges wird bereits permanent eine Temperatur über das gegenüber dem Schmelzbereich angeordnete Quotientenpyrometer impac ISQ 10-LO gemessen. Die t₉₀-Zeit dieses Quotientenpyrometers beträgt gemäß Datenblatt 2 ms. Nach Erreichen des Kernschattens durch die vollständige Unterbrechung des Strahlenganges zwischen Strahlungsquelle und Schmelzbereich und nach Ablauf der zwanzigfachen t₉₀-Zeit (40ms) erfolgt die Messung der Temperatur.

Die Messung ergab eine Temperatur der Schmelze von 1655 °C.

Eine Messung der axialen Temperaturverteilung kann durch Verschieben des Pyrometers und Wiederholen der Messung erfolgen.

## Patentansprüche

1. Verfahren zur pyrometrischen Messung der Temperatur oder der Temperaturverteilung mindestens der Schmelze in Einkristallzüchtungsanlagen, bei denen der Schmelzbereich mittels einer oder mehreren Strahlungsquellen, die mindestens einen IR-Strahlungsanteil enthalten, erwärmt wird, und für eine oder mehrere Temperaturmessungen die Einwirkung der Strahlungsquellen auf den Schmelzbereich unterbrochen und die eine oder mehrere Temperaturmessungen ausschließlich während des Unterbrechungszeitraumes durchgeführt werden, wobei die Unterbrechung mindestens bis zur t₉₀-Zeit eines oder mehrerer Quotientenpyrometer durchgeführt wird, und die Unterbrechung der Einwirkung der Strahlungsquellen auf den Schmelzbereich mittels einer oder mehrerer Einrichtungen vorgenommen wird, die in den Strahlengang zwischen Strahlungsquelle und Schmelzbereich eingebracht werden.

2. Verfahren nach Anspruch 1, bei dem für die Temperaturmessung ein oder mehrere Quotienten-Pyrometer mit einer Einschwingzeit t₉₀ von < 10 ms eingesetzt werden.

3. Verfahren nach Anspruch 1, bei dem die Einwirkung der Strahlungsquellen auf den Schmelzbereich für eine Zeitdauer im Bereich von 2 ms bis 10 s unterbrechen wird.

4. Verfahren nach Anspruch 1, bei dem der pyrometrische Messvorgang im mittleren Bereich des Unterbrechungszeitraumes durchgeführt wird.

5. Verfahren nach Anspruch 1, bei dem der pyrometrische Messvorgang während einer Zeitdauer im Bereich von 10 ms bis 80 ms durchgeführt wird.

6. Verfahren nach Anspruch 1, bei dem die Synchronisation des pyrometrischen Messvorganges mit der Unterbrechung der Einwirkung der Wärmestrahlungsquellen und die Auswertung der Messung elektronisch durchgeführt werden.

7. Verfahren nach Anspruch 1, bei dem die Unterbrechung bis zu dem 10 bis 50fachen der t₉₀-Zeit des Pyrometers durchgeführt wird, wobei die t₉₀-Zeit die Zeit bis zur Anzeige von 90 % des Messwertes ist.

8. Einkristallzüchtungsanlagen mit einer Vorrichtung zur pyrometrischen Messung der Temperatur oder der Temperaturverteilung mindestens der Schmelze von Einkristallzüchtungsanlagen, und mit mindestens einer Strahlungsquelle mit mindestens einem IR-Strahlungsanteil, und mit mindestens einem Quotientenpyrometer und mit mindestens einer Einrichtung zur Unterbrechung der Einwirkungen der Strahlungsquelle auf den Strahlungsbereich, wobei die Schmelze von Einkristallzüchtungsanlagen mittels mindestens einer Strahlungsquelle mit mindestens einem IR-Strahlungsanteil erwärmt ist, für eine oder mehrere Temperaturmessungen die Einwirkung der Strahlungsquellen auf den Schmelzbereich unterbrochen und die eine oder mehrere Temperaturmessungen ausschließlich während des Unterbrechungszeitraumes durchgeführt ist, wobei die Unterbrechung mindestens bis zur t90-Zeit eines oder mehrerer Quotientenpyrometer durchgeführt ist, und die Unterbrechung der Einwirkung der Strahlungsquellen auf den Schmelzbereich mittels einer oder mehrerer Einrichtungen vorgenommen ist, die in den Strahlengang zwischen Strahlungsquelle und Schmelzbereich eingebracht werden.

9. Vorrichtung nach Anspruch 8, bei der die Strahlungsquelle eine IR-Lampe oder eine Halogenlampe oder eine Lichtbogenlampe ist.

10. Vorrichtung nach Anspruch 8, bei der die Einrichtungen zur Unterbrechung der Einwirkung der Strahlungsquelle auf den Strahlungsbereich eine oder mehrere strahlungsdichte Blenden, ein oder mehrere Flüssigkristalle oder eine Vorrichtung zur Veränderung der Strahlungsrichtung der Strahlungsquelle sind.

11. Vorrichtung nach Anspruch 10, bei der eine oder mehrere strahlungsdichte Blenden innerhalb eines Ringes angeordnet sind und der Ring einer kreisförmigen Bewegung unterworfen ist.

12. Vorrichtung nach Anspruch 10, bei der die Flüssigkristalle periodisch mit einer Spannung beauflagt sind, die sie zeitweise für den Durchgang von mindestens IR-Strahlung undurchlässig machen.

13. Vorrichtung nach Anspruch 10, bei der als Vorrichtung zur Veränderung der Strahlungsrichtung der Strahlungsquelle ein Schwenkmechanismus für die Strahlungsquelle oder ein Schwenkmechanismus für Fokussierungseinrichtungen vorhanden sind.

## Claims

1. Method for pyrometrically measuring the temperature or the temperature distribution of at least the melt in facilities for growing single crystals, in which the melt region is heated using one or more radiation sources containing at least one IR radiation component and the action of the radiation sources on the melt region is interrupted for one or more temperature measurements, and the one or more temperature measurements is/are carried out only during the interruption period, wherein the interruption is performed at least up to the t₉₀ time of one or more quotient pyrometers, and the action of the radiation sources on the melt region is interrupted using one or more devices which are introduced into the beam path between radiation source and melt region.

2. Method according to Claim 1, in which one or more quotient pyrometers having a transition time t₉₀ of <10 ms are used for the temperature measurement.

3. Method according to Claim 1, in which the action of the radiation sources on the melt region is interrupted for a period in the range from 2 ms to 10 s.

4. Method according to Claim 1, in which the pyrometric measurement procedure is carried out in the central region of the interruption period.

5. Method according to Claim 1, in which the pyrometric measurement procedure is carried out during a period in the range from 10 ms to 80 ms.

6. Method according to Claim 1, in which the synchronization of the pyrometric measurement procedure with the interruption of the action of the thermal radiation sources and the evaluation of the measurement are carried out electronically.

7. Method according to Claim 1, in which the interruption is effected up to 10 to 50 times the t₉₀ time of the pyrometer, wherein the t₉₀ time is the time up to the indication of 90% of the measurement value.

8. Facilities for growing single crystals having an apparatus for pyrometrically measuring the temperature or the temperature distribution of at least the melt of facilities for growing single crystals, and having at least one radiation source with at least one IR radiation component, and having at least one quotient pyrometer and having at least one device for interrupting the action of the radiation source on the melt region, wherein the melt of facilities for growing single crystals is heated using at least one radiation source with at least one IR radiation component, the action of the radiation sources on the melt region is interrupted for one or more temperature measurements, and the one or more temperature measurements is/are carried out only during the interruption period, wherein the interruption is performed at least up to the t₉₀ time of one or more quotient pyrometers, and the action of the radiation sources on the melt region is interrupted using one or more devices which are introduced into the beam path between radiation source and melt region.

9. Apparatus according to Claim 8, in which the radiation source is an IR lamp or a halogen lamp or an arc lamp.

10. Apparatus according to Claim 8, in which the devices for interrupting the action of the radiation source on the melt region are one or more radiation-opaque screens, one or more liquid crystals or an apparatus for changing the radiation direction of the radiation source.

11. Apparatus according to Claim 10, in which one or more radiation-opaque screens are arranged within a ring, and the ring is subjected to a circular movement.

12. Apparatus according to Claim 10, in which a voltage is periodically applied to the liquid crystals, which temporarily renders them non-transmissive to the passage of at least IR radiation.

13. Apparatus according to Claim 10, in which, as the apparatus for changing the radiation direction of the radiation source, a pivot mechanism for the radiation source or a pivot mechanism for focusing devices is provided.

## Revendications

1. Procédé de mesure pyrométrique de la température ou de la répartition des températures au moins du bain de fusion dans des installations de formation de monocristaux dans lesquelles la partie fondue est chauffée au moyen d'une ou plusieurs sources de rayonnement dont au moins une partie rayonne dans l'IR,
l'effet des sources de rayonnement sur la partie fondue étant interrompu en vue d'une ou plusieurs mesures de température et la ou les mesures de température étant exécutées exclusivement pendant la durée de l'interruption,
l'interruption étant réalisée au moins jusqu'à la durée t₉₀ d'un ou de plusieurs pyromètres à quotient et l'interruption de l'action des sources de rayonnement sur la partie fondue étant réalisée au moyen d'un ou plusieurs dispositifs qui sont placés dans le parcours des rayons entre la source de rayonnement et la partie fondue.

2. Procédé selon la revendication 1, dans lequel la mesure de température utilise un ou plusieurs pyromètres à quotient dont la durée des transitoires t₉₀ est < 10 ms.

3. Procédé selon la revendication 1, dans lequel l'effet des sources de rayonnement sur la partie fondue est interrompu pendant une durée de l'ordre de 2 ms à 10 s.

4. Procédé selon la revendication 1, dans lequel l'opération de mesure pyrométrique est réalisée dans la partie centrale de la durée d'interruption.

5. Procédé selon la revendication 1, dans lequel l'opération de mesure pyrométrique est réalisée pendant une durée de l'ordre de 10 ms à 80 ms.

6. Procédé selon la revendication 1, dans lequel la synchronisation de l'opération de mesure pyrométrique est réalisée en même temps que l'interruption de l'effet des sources de rayonnement thermique, l'évaluation de la mesure étant réalisée par voie électronique.

7. Procédé selon la revendication 1, dans lequel l'interruption est exécutée jusqu'à 10 à 50 fois la durée t₉₀ du pyromètre, la durée t₉₀ étant la durée nécessaire pour afficher 90 % de la valeur de mesure.

8. Installations de formation de monocristaux dotées d'un dispositif de mesure pyrométrique de la température ou de la répartition des températures au moins du bain de fusion d'installations de formation de monocristaux, ainsi que d'au moins une source de rayonnement dont au moins une partie rayonne dans l'IR et que d'au moins un pyromètre à quotient et un dispositif d'interruption des effets de la source de rayonnement sur la partie fondue,
la partie fondue d'installations de formation de monocristaux étant chauffée au moyen d'au moins une source de rayonnement dont au moins une partie rayonne dans l'IR, l'effet des sources de rayonnement sur la partie fondue étant interrompu pendant une ou plusieurs mesures de température et la ou les mesures de température étant réalisées exclusivement pendant la durée de l'interruption, l'interruption étant réalisée au moins jusqu'à la durée t₉₀ d'un ou plusieurs pyromètres à quotient, l'interruption de l'effet des sources de rayonnement sur la partie fondue étant réalisée au moyen d'un ou plusieurs dispositifs placés dans le parcours de rayonnement entre la source de rayonnement et la partie fondue.

9. Dispositif selon la revendication 8, dans lequel la source de rayonnement est une lampe à IR, une lampe à halogène ou une lampe à arc lumineux.

10. Dispositif selon la revendication 8, dans lequel le dispositif d'interruption de l'effet de la source de rayonnement sur la partie fondue est formé d'un ou de plusieurs écrans opaques au rayonnement, d'un ou de plusieurs cristaux liquides ou d'un ensemble permettant de modifier la direction de rayonnement de la source de rayonnement.

11. Dispositif selon la revendication 10, dans lequel un ou plusieurs écrans opaques au rayonnement sont disposés à l'intérieur d'un anneau, l'anneau subissant un déplacement circulaire.

12. Dispositif selon la revendication 10, dans lequel une tension est appliquée périodiquement sur les cristaux liquides et les rend temporairement opaques au passage d'au moins le rayonnement IR.

13. Dispositif selon la revendication 10, dans lequel le dispositif utilisé pour modifier la direction du rayonnement de la source de rayonnement est un mécanisme de pivotement de la source de rayonnement ou un mécanisme de pivotement de dispositifs de focalisation.
